# EUROPÄISCHE PATENTSCHRIFT

(11) **EP 2 145 977 B1**
(45) Veröffentlichungstag und Bekanntmachung des Hinweises auf die Patenterteilung: **28.08.2013**
(21) Anmeldenummer: 09163356.0
(22) Anmeldetag: 22.06.2009
(51) Int. Cl.: C23C 16/30, C23C 16/40, C23C 16/453, C23C 16/513, C23C 24/00, C23C 16/04

(54) **Verfahren zur Abscheidung von Schichten auf einem Substrat**
Method for depositing layers on a substrate
Procédé destiné au dépôt de couches sur un substrat

(30) Priorität: 18.07.2008 DE 102008033938
(43) Veröffentlichungstag der Anmeldung: 20.01.2010
(73) Patentinhaber: Innovent e.V., 07745 Jena (DE)
(72) Erfinder: Pfuch, Andreas, 99510 Apolda (DE); Schubert, Tim, 95448 Bayreuth (DE); Schimanski, Arnd, 44329 Dortmund (DE); Grünler, Bernd, 07937 Zeulenroda (DE)
(74) Vertreter: Liedtke, Markus

(56) Entgegenhaltungen:
- WO-A2-2007/051994
- DE-A1- 19 958 473
- US-A1- 2006 121 196
- BALANI ET AL: "In situ carbon nanotube reinforcements in a plasma-sprayed aluminum oxide nanocomposite coating", ACTA MATERIALIA, ELSEVIER, OXFORD, GB, Bd. 56, Nr. 3, 3. Dezember 2007 (2007-12-03), Seiten 571-579, XP022419160, ISSN: 1359-6454, DOI: DOI:10.1016/J.ACTAMAT.2007.10.038

## Beschreibung

Die Erfindung betrifft ein Verfahren zur Abscheidung von Schichten auf einem Substrat.

Um die Oberflächeneigenschaften verschiedener Substrate zu beeinflussen, sind seit geraumer Zeit Beschichtungsverfahren gebräuchlich, bei denen Beschichtungsstoffe aus einer Gasphase auf einer Oberfläche abgeschieden werden. Dabei wird unter anderem zwischen chemischen und physikalischen Gasphasenabscheidungen unterschieden. Bei den chemischen Verfahren werden meist so genannte Precursoren, Vorläuferstoffe der Beschichtungsstoffe, mittels Energiezuführung umgesetzt, Reaktionsprodukte der Precursoren auf die Oberfläche geleitet und dort abgelagert. Die Energiezuführung kann beispielsweise mittels Beflammung erfolgen. Der der Flamme zugeführte Precursor bildet bei seiner thermischen Umsetzung Partikel, insbesondere Nanopartikel, die noch in der Flamme agglomerieren und sich dann an der Oberfläche absetzen. Auf diese Weise ist eine homogene und dichte Beschichtung möglich, jedoch unter hohem Energieeinsatz. Eine andere Möglichkeit bieten so genannte Niederdruckplasmaverfahren, bei denen der Precursor in einer Plasmaquelle oder in deren räumlicher Nähe auf den zu beschichtenden Oberflächen zu Dünnschichten umgesetzt wird. Dieses energetisch vorteilhafte Verfahren benötigt allerdings evakuierte Prozesskammern und ist daher aufwändig und unflexibel.

Seit einigen Jahren sind so genannte Normaldruckplasmaverfahren bekannt, bei denen die zu beschichtenden Oberflächen nicht in ein Vakuum eingebracht werden müssen. Die Partikelbildung erfolgt hierbei schon im Plasma. Die Homogenität der abgeschiedenen Schichten ist, eine geeignete Führung des Substrats vorausgesetzt, mit den durch Beflammung erzielten vergleichbar, der erforderliche Energieeintrag ist jedoch wesentlich geringer.

Aus der DE 199 58 473 A1, der DE 199 58 474 A1 und der US 2003/0215644 A1 sind gattungsgemäße Verfahren zum Beschichten von Substraten bekannt. Bei diesen bekannten Verfahren wird aus einem Arbeitsgas eine Flamme oder ein Plasmastrahl erzeugt, in die jeweils ein Precusor eingebracht wird.

Nachteilig ist dabei, dass mit bekannten Verfahren hergestellte Funktionsschichten ungünstige Eigenschaften aufweisen. Insbesondere sind die tribologischen, elektrischen, optischen oder thermischen Eigenschaften der mit bekannten Verfahren hergestellte Funktionsschichten ungünstig.

Der Erfindung liegt die Aufgabe zu Grunde, ein verbessertes Verfahren zur Abscheidung von Schichten anzugeben.

Die Aufgabe wird erfindungsgemäß gelöst durch die in Anspruch 1 angegebenen Merkmale.

Vorteilhafte Ausgestaltungen der Erfindung sind Gegenstand der Unteransprüche.

Bei einem erfindungsgemäßen Verfahren zur Abscheidung von Schichten auf einem Substrat wird aus einem Arbeitsgas ein Plasmastrahl oder eine Flamme erzeugt. Dabei wird mindestens ein Precursormaterial dem Arbeitsgas und/oder dem Plasmastrahl und/oder der Flamme zugeführt und im Plasmastrahl oder der Flamme zur Reaktion gebracht. Dies bewirkt eine Abscheidung von zumindest einem Reaktionsprodukt mindestens eines der Precursoren auf einer Oberfläche des Substrats und/oder auf mindestens einer auf der Oberfläche angeordneten Schicht. Bei dem erfindungsgemäßen Verfahren ist mindestens einer der Precursoren mit Nanopartikeln versetzt, wodurch die Nanopartikel in mindestens eine der abgeschiedenen Schichten eingebettet werden. Alternativ dazu sind die Nanopartikel in einer Dispersion enthalten, die dem Arbeitsgas und/oder dem Plasmastrahl und/oder der Flamme zusätzlich zum Precursor zugeführt wird. Das Beflammungsverfahren ist insbesondere eine Pyrosilbeflammung.

Als Nanopartikel wird in diesem Zusammenhang ein Verbund von Atomen und/oder Molekülen verstanden, dessen Größe typischerweise in einem Bereich von einem bis einigen hundert Nanometern liegt. Nanopartikel weisen gegenüber größeren Partikeln bzw. Festkörpern deutlich veränderte Eigenschaften beispielsweise in Bezug auf chemische Reaktivität, tribologische Eigenschaften oder elektrische Leitfähigkeit auf. Eine Verwendung dieser Nanopartikel im Bereich der Beschichtungstechnologie eröffnet neue Möglichkeiten der Oberflächenmodifikation.

Das Verfahren wird bevorzugt bei Atmosphärendruck durchgeführt, wodurch auf besonders vorteilhafte Weise ein zeitaufwändiger Prozessschritt des Evakuierens einer Prozesskammer sowie Apparaturen zur Vakuumerzeugung, wie Vakuumpumpen und Prozesskammer, eingespart wird. Dadurch lässt sich das Verfahren ohne großen Aufwand in eine Prozesskette integrieren, die eine Herstellung und Vergütung des Substrats beinhaltet.

Ebenso kann eine Beschichtung mittels r-C-CVD (remote combustion chemical vapor deposition) erfolgen.

Erfindungsgemäß werden als Nanopartikel Kohlenstoffnanoröhrchen, Kohlenstoffplatelets, Silberpartikel, silberhaltige Kohlenstoffnanoröhrchen und/oder silberbehaftete Kohlenstoffplatelets verwendet. Kohlenstoffnanoröhrchen sind ein- oder mehrwandig aufgerollte Graphitlagen. Ein Durchmesser dieser Röhrchen liegt im Bereich weniger Nanometer. Nichtaufgerollte Graphitlagen, deren Abmessungen im Nanometerbereich liegen, werden als Kohlenstoffplatelets bezeichnet. Es ist möglich, diesen Kohlenstoffnanopartikeln Silberpartikel, ebenfalls im Nanometerbereich, beizumischen, wodurch die Eigenschaften der Kohlenstoffnanopartikel verändert werden.

Weiterhin ist es möglich, die Kohlenstoffnanopartikel zumindest teilweise mit einer Silberbelegung zu versehen, wodurch Eigenschaften der Kohlenstoffnanopartikel verändert werden. Das Anbinden der Silberpartikel an die Kohlenstoffnanopartikel erfolgt bevorzugt durch mikrowellenbasierte Verfahren.

Der erfindungsgemäße Einbau der Kohlenstoffplatelets in eine Funktionsschicht ermöglicht es, unter anderem tribologische Eigenschaften eines zu beschichtenden Materials zu verbessern. Beispielsweise ist es möglich, Gleiteigenschaften zwischen verschiedenen Reibepartnern günstig zu beeinflussen. Des Weiteren sind Kohlenstoffnanoröhrchen je nach Struktur halbleitend, metallisch leitend oder supraleitend; sie sind reißfest und sowohl thermisch als auch chemisch äußerst stabil. Mit dem erfindungsgemäßen Einbau der Kohlenstoffnanoröhrchen in eine Funktionsschicht können somit beispielsweise auch die elektrischen, optischen oder thermischen Eigenschaften der Funktionsschicht optimiert werden. Damit erhält das moderne Gebiet der Nanotechnologie eine neue, vielversprechende Möglichkeit, bei Atmosphärendruck Schichten herzustellen bzw. Oberflächen zu modifizieren.

In Bezug auf Silberpartikel, silberhaltige Kohlenstoffnanoröhrchen oder silberbehaftete Kohlenstoffplatelets steht eine antiinfektiöse Eigenschaft des Silbers im Vordergrund einer Schichtentwicklung, beispielsweise für eine Beschichtung von Produkten, bei denen eine bakterizide Wirkung erzielt werden soll, wie zum Beispiel Implantate oder Prothesen.

Als Precursor werden vorzugsweise silizium-, titan- und/oder aluminiumorganische Verbindungen verwendet, wobei die Precursoren flüssig und/oder gasförmig vorliegen. Bei Verwendung eines flüssigen Precursors wird dieser vorzugsweise vor dem Einleiten in das Arbeitsgas oder den Plasmastrahl oder die Flamme in den gasförmigen Zustand überführt.

In einer Ausgestaltung der Erfindung werden die Nanopartikel derart vorbehandelt, dass sie in einem Dispergiermittel und/oder einem der Precursoren dispergiert werden können. Aufgrund ihrer physikalischen und chemischen Eigenschaften können Nanopartikel nur unzureichend in einem Dispergiermedium verteilt werden. Mit einer geeigneten Vorbehandlung, zum Beispiel mittels eines Plasmas, können die Nanopartikel derart aktiviert werden, dass sie in einem geeigneten Dispersionsmittel bzw. einem Precursor dispergiert werden können. Die Dispersion kann über eine geeignete Flüssigdosierung vernebelt und zum Beispiel dem bereits mit dem Precursor befrachteten Gasstrom zugeführt werden.

Als Arbeitsgas kann ein Gas oder Aerosol, vorzugsweise Luft, Sauerstoff, Stickstoff, Edelgase, Wasserstoff, Kohlendioxid, gasförmige Kohlenwasserstoffe, Ammoniak oder ein Gemisch wenigstens zweier der vorgenannten Gase verwendet werden. Ammoniak eignet sich beispielsweise zur Bildung von Nitriden und kann eine katalytische Wirkung bei der Umsetzung des Precursors aufweisen.

In einer Ausgestaltung der Erfindung wird mindestens eine Gradientenschicht abgeschieden. Als Gradientenschicht soll eine Schicht verstanden werden, deren Zusammensetzung sich über ihre Dicke allmählich ändert. Der Begriff wird in Abgrenzung zu benachbarten Schichten mit verschiedenen Eigenschaften verwendet, die eine klare Grenze aufweisen.

Es kann mindestens eine Silizium-, Titan- und/oder Aluminiumoxidschicht abgeschieden werden.

Eine vorteilhafte Ausgestaltung der Erfindung sieht vor, dass ein Durchsatz des Arbeitsgases und/oder des Precursors gesteuert und/oder geregelt wird.

Weiterhin kann ein Nanopartikelanteil im Precursor und/oder in der Dispersion gesteuert und/oder geregelt werden. Neben dem Durchsatz des Arbeitsgases und/oder des Precursors steht somit eine weitere Möglichkeit zur Beeinflussung der Schichteigenschaften bzw. zum Aufbau von Gradienten innerhalb einer Schicht zur Verfügung. Durch geeignete Wahl dieser Prozessparameter und der verwendeten Precursoren und der verwendeten Nanopartikel sind beispielsweise folgende Eigenschaften des Substrats gezielt veränderbar: Kratzfestigkeit, Selbstheilungsfähigkeit, Reflexionsverhalten, Transmissionsverhalten, Brechungsindex, Transparenz, Lichtstreuung, elektrische Leitfähigkeit, Reibung, Haftung, Hydrophilie, Hydrophobie, Oleophilie, Oleophobie, Oberflächenspannung, Oberflächenenergie, antikorrosive Wirkung, Schmutz abweisende Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, antibakterielles Verhalten, elektrostatisches Verhalten, elektrochrome Aktivität, photochrome Aktivität, und gasochrome Aktivität.

Als Substrate können unter anderem Metalle, Glas, Keramiken und Kunststoffe verwendet werden. Kunststoffmaterialien sind insbesondere aufgrund des moderaten Energieeintrags des Normaldruckplasmas beschichtbar, ohne dass das Substrat zerstört wird.

In einer weiteren Ausgestaltung der Erfindung wird als Substrat ein Hohlkörper verwendet. Die Abscheidung findet dabei auf einer Innenfläche des Hohlkörpers statt, wobei der Plasmastrahl oder die Flamme durch eine erste Öffnung des Hohlkörpers eingeleitet wird. Vorzugsweise werden der Plasmastrahl oder die Flamme und/oder Reaktionsgase des Plasmastrahls oder der Flamme durch eine zweite Öffnung des Hohlkörpers abgesaugt. Somit besteht die Möglichkeit, beispielsweise Spritzenkörper von innen mit einer Barriereschicht zu versehen oder eine Reibungsminderungsschicht aufzubringen.

Vorzugsweise wird vor dem Abscheiden ein Aktivierungsprozess durchgeführt, bei dem der Plasmastrahl oder die Flamme ohne Zufuhr eines Precursormaterials in den Hohlkörper eingebracht wird. Dadurch wird die innere Oberfläche des Hohlkörpers gereinigt und aktiviert, was eine bessere Haftung anschließend aufgebrachter Schichten zur Folge hat.

Weiterhin kann die erste Innenbeschichtung direkt im Anschluss an einen Herstellungsprozess des Hohlkörpers, bei dem der Hohlkörper unter Hitzezufuhr gebildet wurde, stattfinden. Dadurch kann der Aktivierungsschritt eingespart werden. Vorteilhafter Weise rotiert der Hohlkörper während des Beschichtungsprozesses um eine Längsachse, um eine homogene Aktivierung bzw. Beschichtung der inneren Oberfläche des Hohlkörpers zu erzielen.

Die Homogenität der Aktivierung bzw. Beschichtung kann auch durch eine Rotation eines Plasmabrenners oder eines Flammenbrenners erreicht werden.

Vorzugsweise ist eine Außenelektrode des Plasmabrenners oder der Flammenbrenner derart ausgestaltet, dass sie oder er durch die erste Öffnung in Richtung der Längsachse des Hohlkörpers eingeführt werden kann.

Weiterhin wird durch eine Absaugung an der zweiten Öffnung des Hohlkörpers der Plasmastrahl oder die Flamme durch den gesamten Hohlkörper geleitet, was eine homogene Aktivierung bzw. Beschichtung in Längsrichtung des Hohlkörpers ermöglicht.

Der Beschichtungsprozess umfasst einen oder mehrere Beschichtungsdurchläufe, bei denen die Außenelektrode des Plasmabrenners oder der Flammenbrenner vorzugsweise in den Hohlkörper eingeführt und in dessen Längsrichtung bewegt wird, so dass der Hohlkörper einmal oder mehrmals hintereinander von innen beschichtet wird.

Bevorzugt liegt eine Temperatur des Hohlkörpers in einem Bereich von 20 °C bis 200 °C, besonders bevorzugt in einem Bereich von 20 °C bis 120 °C, insbesondere in einem Bereich von 20 °C bis 80 °C.

Mit dem Verfahren können in der Schicht beispielsweise mindestens ein Oxid und/oder ein Nitrid und/oder ein Oxinitrid mindestens eines der Elemente Silizium, Titan, Aluminium, Molybdän, Wolfram, Vanadium, Zirkon oder Bor abgeschieden werden. Für die Abscheidung von Silizium-, Titan- und/oder Aluminiumoxidschichten werden vorzugsweise silizium-, titan- und/oder aluminiumorganische Verbindungen als Precursoren verwendet. Solche Schichten sind besonders als Barriereschutzschichten oder Kratzschutzschichten geeignet.

Besonders bevorzugt wird mindestens eine der abgeschiedenen Schichten als Diffusionsbarriere gegenüber mindestens einem Alkalielement, beispielsweise Natrium oder Kalium, und/oder gegenüber mindestens einem Erdalkalielement, beispielsweise Magnesium oder Kalzium, und/oder gegenüber Bor und/oder insbesondere gegenüber Wolfram ausgeführt.

Das Verfahren ist nicht auf die Beschichtung von Spritzenkörpern beschränkt. Vielmehr kann es auch für andere Hohlkörper, insbesondere Rohre und andere Endlosmaterialien beliebiger Größe, beispielsweise für Pipelines, verwendet werden.

Insbesondere zur Beschichtung von Rohren und anderem Endlosmaterial kann das Arbeitsgas mit dem Precursor in den Hohlkörper eingeleitet und das Plasma im Hohlkörper mittels von außerhalb des Hohlkörpers in den Hohlkörper eingekoppelter Energie gezündet werden.

Die Zündung des Plasmas kann beispielsweise mittels Hochfrequenzanregung induktiv oder kapazitiv oder mittels Mikrowellenstrahlung erfolgen.

Ein Ausführungsbeispiel der Erfindung wird im Folgenden anhand einer Zeichnung näher erläutert.

Darin zeigt:

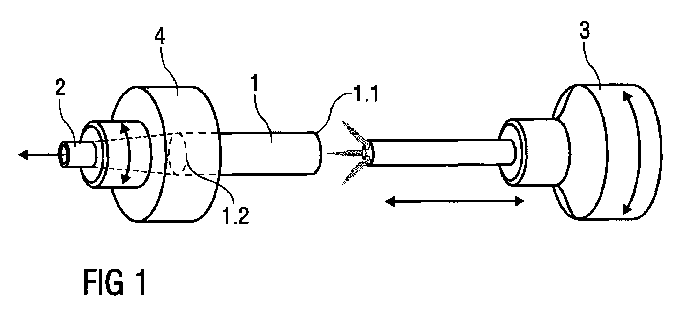

- Figur 1: eine schematische Darstellung einer Vorrichtung zur Innenbe- schichtung eines Hohlkörpers mittels eines Plasmabrenners.

**Figur 1** zeigt schematisch eine Vorrichtung zur Innenbeschichtung eines Substrats 1 in Gestalt eines Hohlkörpers mit einer Absaugeinrichtung 2 und einem Plasmabrenner 3. Der Plasmabrenner 3 wird in eine erste Öffnung 1.1 in Längsrichtung des Substrats 1 eingeführt. Die Absaugeinrichtung 2 ist an eine zweite Öffnung 1.2 des Substrats 1 angeschlossen. Dabei wird durch die erste Öffnung 1.1 des Substrats 1 ein Plasma unter Atmosphärendruck eingeleitet und das Plasma oder ein Reaktionsgas des Plasmas durch die zweite Öffnung 1.2 des Substrats 1 abgesaugt.

Bei einer Abscheidung von Schichten auf einem Substrat 1 wird aus einem Arbeitsgas ein Plasmastrahl erzeugt. Dem Arbeitsgas und/oder dem Plasmastrahl wird mindestens ein Precursormaterial zugeführt und im Plasmastrahl zur Reaktion gebracht. Es wird dabei mindestens ein Reaktionsprodukt mindestens eines der Precursoren auf einer Oberfläche des Substrats 1 und/oder auf mindestens einer auf der Oberfläche angeordneten Schicht abgeschieden, wobei mindestens einer der Precursoren mit Nanopartikeln versetzt ist oder wobei dem Arbeitsgas und/oder dem Plasmastrahl eine Nanopartikel enthaltende Suspension zugesetzt wird. Die Nanopartikel werden in mindestens eine der abgeschiedenen Schichten eingebettet.

Das Verfahren wird vorzugsweise bei Atmosphärendruck durchgeführt.

Als Hohlkörper kann beispielsweise ein Spritzenkörper beschichtet werden.

Als Nanopartikel werden Kohlenstoffnanoröhrchen und/oder Kohlenstoffplatelets und/oder Silberpartikel und/oder silberhaltige Kohlenstoffnanoröhrchen und/oder silberbehaftete Kohlenstoffplatelets verwendet.

Mit dem Verfahren können in der Schicht beispielsweise mindestens ein Oxid und/oder ein Nitrid und/oder ein Oxinitrid mindestens eines der Elemente Silizium, Titan, Aluminium, Molybdän, Wolfram, Vanadium, Zirkon oder Bor abgeschieden werden. Für die Abscheidung von Silizium-, Titan- und/oder Aluminiumoxidschichten werden vorzugsweise silizium-, titan- und/oder aluminiumorganische Verbindungen als Precursoren verwendet.

Vorzugsweise wird ein flüssiger und/oder gasförmiger Precursor verwendet, wobei ein flüssiger Precursor vor dem Einleiten in das Arbeitsgas oder den Plasmastrahl in den gasförmigen Zustand überführt wird.

In einer Ausführungsform werden die Nanopartikel derart vorbehandelt, dass eine Dispersion aus Nanopartikeln und einem Dispersionsmedium und/oder einem der Precursoren hergestellt werden kann.

Als Arbeitsgas kann ein Gas oder Aerosol, beispielsweise Luft, Sauerstoff, Stickstoff, Edelgase, Wasserstoff, Kohlendioxid, gasförmige Kohlenwasserstoffe, Ammoniak oder ein Gemisch wenigstens zweier der vorgenannten Gase verwendet werden.

In einer Ausgestaltung der Erfindung kann mindestens eine der Schichten als eine Gradientenschicht abgeschieden wird.

Weiterhin kann mindestens eine der Schichten als eine Siliziumoxid- und/oder Titanoxid- und/oder Aluminiumoxidschicht abgeschieden wird.

In einer weiteren Ausführungsform kann ein Durchsatz des Arbeitsgases und/oder des Precursors gesteuert und/oder geregelt werden.

In einer anderen Ausführungsform kann ein Nanopartikelanteil im Precursor gesteuert und/oder geregelt werden.

Mittels mindestens einer der abgeschiedenen Schichten lässt sich mindestens eine der Eigenschaften des Substrats 1 Kratzfestigkeit, Barriereverhalten, Transmissionsverhalten, Brechungsindex, Lichtstreuung, elektrische Leitfähigkeit, antibakterielles Verhalten, Reibung, Haftung, Hydrophilie, Hydrophobie, Oleophobie, Oleophilie, Oberflächenspannung, Oberflächenenergie, antikorrosive Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, elektrostatisches Verhalten, elektrochrome Aktivität, photochrome Aktivität und gasochrome Aktivität verändern.

Des Weiteren kann mindestens eine der abgeschiedenen Schichten als Diffusionsbarriere gegenüber mindestens einem Alkalielement, beispielsweise Natrium oder Kalium, und/oder gegenüber mindestens einem Erdalkalielement, beispielsweise Magnesium oder Kalzium, und/oder gegenüber Bor und/oder insbesondere gegenüber Wolfram ausgeführt sein.

In einer anderen Ausführungsform kann statt eines Plasmabrenners 3 ein Flammenbrenner verwendet werden.

Weiterhin kann vor dem Abscheiden ein Aktivierungsprozess durchgeführt wird, bei dem der Plasmastrahl ohne Zufuhr eines Precursormaterials in den Hohlkörper eingebracht wird.

Weiterhin kann die Abscheidung direkt im Anschluss an einen Herstellungsprozess des Hohlkörpers, bei dem der Hohlkörper unter Hitzezufuhr gebildet wurde, stattfinden.

Vorzugsweise wird der Hohlkörper während des Beschichtungsprozesses durch eine Probenrotationseinrichtung 4 um eine Längsachse rotiert.

In einer anderen Ausführungsform kann der den Plasmastrom emittierende Plasmabrenner 3 während des Beschichtungsprozesses um eine Längsachse rotieren. Vorzugsweise ist eine Außenelektrode des Plasmabrenners 3 derart ausgestaltet, dass der Plasmabrenner 3 durch die erste Öffnung 1.1 in Richtung der Längsachse des Hohlkörpers einführbar ist.

Durch eine Absaugung 2 an der zweiten Öffnung 1.2 des Hohlkörpers wird der Plasmastrahl vorteilhafter Weise durch den gesamten Hohlkörper geleitet.

In einer Ausgestaltungsform beinhaltet ein Beschichtungsprozess einen oder mehrere Beschichtungsdurchläufe, bei denen die Außenelektrode des Plasmabrenners 3 in den Hohlkörper eingeführt und in dessen Längsrichtung bewegt wird, so dass der Hohlkörper einmal oder mehrmals hintereinander von innen beschichtet wird.

Eine Temperatur des Hohlkörpers liegt vorzugsweise in einem Bereich von 20 °C bis 200 °C liegt.
Die Absaugeinrichtung 2 ist optional und für das Verfahren nicht zwingend erforderlich. Es können auch Hohlkörper 1 beschichtet werden, die nur die erste Öffnung aufweisen und ansonsten geschlossen sind.

Das Verfahren kann auch für andere Hohlkörper 1, insbesondere Rohre und andere Endlosmaterialien beliebiger Größe, beispielsweise für Pipelines, verwendet werden.

Insbesondere zur Beschichtung von Rohren und anderem Endlosmaterial kann das Arbeitsgas mit dem Precursor in den Hohlkörper eingeleitet und das Plasma im Hohlkörper mittels von außerhalb des Hohlkörpers in den Hohlkörper eingekoppelter Energie gezündet werden.

Die Zündung des Plasmas kann beispielsweise mittels Hochfrequenzanregung induktiv oder kapazitiv oder mittels Mikrowellenstrahlung erfolgen.

Statt des gezeigten Hohlkörpers kann auch ein geometrisch anders gestaltetes Substrat 1 beschichtet werden. Gegebenenfalls kann die Rotation des Substrats 1 oder des Plasmabrenners 3 sowie die Absaugung dann entfallen.

Als Substrat 1 können unter anderem Metalle, Glas, Keramiken und Kunststoffe verwendet werden.

Mit dem Verfahren können insbesondere folgende Beschichtungen realisiert werden:
- Modifizierung von Dünnschichten hinsichtlich Transmission und Leitfähigkeit
- Bakterizide Beschichtungen
- Transparente leitfähige Schichten
- SiO₂ - TiO₂-Entspiegelungsschichten mit selbstreinigenden bakteriziden Eigenschaften
- Schichten gegen statische Aufladungen
- EMV-Abschirmungen
- oleophobe oder oleophile Beschichtungen zur Beeinflussung einer Verteilung von Schmierstoffen oder für Mikroskopanwendungen
- Kratzschutzschichten

### BEZUGSZEICHENLISTE

- 1.: Substrat
- 1.1.: erste Öffnung
- 1.2.: zweite Öffnung
- 2.: Absaugeinrichtung
- 3.: Plasmabrenner
- 4.: Probenrotationseinrichtung

## Patentansprüche

1. Verfahren zur Abscheidung einer Schicht auf einem Substrat (1), bei dem aus einem Arbeitsgas ein Plasmastrahl oder eine Flamme erzeugt wird, wobei mindestens ein Precursormaterial dem Arbeitsgas und/oder dem Plasmastrahl und/oder der Flamme zugeführt und im Plasmastrahl oder der Flamme zur Reaktion gebracht wird und wobei mindestens ein Reaktionsprodukt mindestens eines der Precursoren auf einer Oberfläche des Substrats (1) und/oder auf mindestens einer auf der Oberfläche angeordneten Schicht abgeschieden wird, wobei mindestens einer der Precursoren mit Nanopartikeln versetzt ist oder wobei dem Arbeitsgas und/oder dem Plasmastrahl und/oder der Flamme eine mit Nanopartikeln versetzte Dispersion zugeführt wird, wobei die Nanopartikel in mindestens eine der abgeschiedenen Schichten eingebettet werden, **dadurch gekennzeichnet, dass** als Nanopartikel Kohlenstoffnanoröhrchen und/oder Kohlenstoffplatelets und/oder Silberpartikel und/oder silberhaltige Kohlenstoffnanoröhrchen und/oder silberbehaftete Kohlenstoffplatelets verwendet werden.

2. Verfahren nach Anspruch 1, **dadurch gekennzeichnet, dass** das Verfahren bei Atmosphärendruck durchgeführt wird.

3. Verfahren nach einem der vorhergehenden Ansprüche, **dadurch gekennzeichnet, dass** als Precursor eine siliziumorganische- und/oder titanorganische- und/oder aluminiumorganische Verbindung verwendet wird.

4. Verfahren nach einem der vorhergehenden Ansprüche, **dadurch gekennzeichnet, dass** die Nanopartikel in einem Dispersionsmedium und/oder einem als Dispersionsmittel dienenden der Precursoren dispergiert werden.

5. Verfahren nach einem der vorhergehenden Ansprüche, **dadurch gekennzeichnet, dass** eines der Arbeitsgase Luft, Sauerstoff, Stickstoff, Edelgase, Wasserstoff, Kohlendioxid, Ammoniak, gasförmige Kohlenwasserstoffe oder ein Gemisch wenigstens zweier der vorgenannten Gase verwendet wird.

6. Verfahren nach einem der vorhergehenden Ansprüche, **dadurch gekennzeichnet, dass** mindestens eine der Schichten als eine Gradientenschicht abgeschieden wird.

7. Verfahren nach einem der vorhergehenden Ansprüche, **dadurch gekennzeichnet, dass** mindestens eine der Schichten als eine Siliziumoxid- und/oder Titanoxid- und/oder Aluminiumoxidschicht abgeschieden wird.

8. Verfahren nach einem der vorhergehenden Ansprüche, **dadurch gekennzeichnet, dass** mittels mindestens einer der abgeschiedenen Schichten mindestens eine der Eigenschaften des Substrats (1) Kratzfestigkeit, Barriereverhalten, Transmissionsverhalten, Brechungsindex, Lichtstreuung, elektrische Leitfähigkeit, antibakterielles Verhalten, Reibung, Haftung. Hydrophilie, Hydrophobie, Oleophobie, Oleophilie, Oberflächenspannung, Oberflächenenergie, antikorrosive Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, elektrostatisches Verhalten, elektrochrome Aktivität verändert wird.

9. Verfahren nach einem der vorhergehenden Ansprüche, **dadurch gekennzeichnet, dass** vor dem Abscheiden ein Aktivierungsprozess durchgeführt wird, bei dem das Substrat (1) mit dem Plasmastrahl oder der Flamme ohne Zufuhr eines Precursormaterials behandelt wird.

10. Verfahren nach einem der vorhergehenden Ansprüche, **dadurch gekennzeichnet, dass** die Abscheidung direkt im Anschluss an einen Herstellungsprozess des Substrats (1), bei dem das Substrat (1) unter Hitzezufuhr gebildet wurde, stattfindet.

11. Verfahren nach einem der vorhergehenden Ansprüche, **dadurch gekennzeichnet, dass** eine Temperatur des Substrats (1) in einem Bereich von 20 °C bis 200 °C liegt.

12. Verfahren nach einem der vorhergehenden Ansprüche, **gekennzeichnet durch** die Beschichtung eines Substrats (1) aus einem der Stoffe Glas, Kunststoff, Metall und Keramik.

13. Verfahren nach einem der vorhergehenden Ansprüche, **dadurch gekennzeichnet, dass** in der Schicht mindestens ein Oxid und/oder ein Nitrid und/oder ein Oxinitrid mindestens eines der Elemente Silizium, Titan, Aluminium, Molybdän, Wolfram, Vanadium, Zirkon oder Bor abgeschieden wird.

14. Verfahren nach einem der vorhergehenden Ansprüche, **dadurch gekennzeichnet, dass** mindestens eine der abgeschiedenen Schichten als Diffusionsbarriere gegenüber mindestens einem Alkalielement und/oder mindestens einem Erdalkalielement und/oder Bor und/oder Wolfram ausgeführt wird.

15. Verfahren nach einem der vorhergehenden Ansprüche, **dadurch gekennzeichnet, dass** mindestens eine der abgeschiedenen Schichten als Diffusionsbarriere gegenüber mindestens einem der Stoffe Sauerstoff, Wasser, Wasserdampf, Kohlendioxid und/oder organischen Lösemitteln, insbesondere aus Kunststoffen ausgeführt wird.

## Claims

1. Method for depositing a layer on a substrate (1), wherein a plasma jet or a flame is generated from a working gas, with at least one precursor material being supplied to the working gas and/or the plasma jet and/or the flame and reacted in the plasma jet or the flame, and with at least one reaction product of at least one of the precursors being deposited on a surface of the substrate (1) and/or on at least one layer disposed on the surface, at least one of the precursors having been admixed with nanoparticles, or a dispersion admixed with nanoparticles being supplied to the working gas and/or to the plasma jet and/or to the flame, the nanoparticles being embedded into at least one of the deposited layers, **characterized in that** nanoparticles used are carbon nanotubes and/or carbon platelets and/or silver particles and/or silver-containing carbon nanotubes and/or silver-bearing carbon platelets.

2. Method according to Claim 1, **characterized in that** the method is carried out under atmospheric pressure.

3. Method according to either of the preceding claims, **characterized in that** an organosilicon and/or organotitanium and/or organoaluminium compound is used as precursor.

4. Method according to any of the preceding claims, **characterized in that** the nanoparticles are dispersed in a dispersion medium and/or in one of the precursors that serves as a dispersion agent.

5. Method according to any of the preceding claims, **characterized in that** one of the working gases is air, oxygen, nitrogen, noble gases, hydrogen, carbon dioxide, ammonia, gaseous hydrocarbons or a mixture of at least two of the aforementioned gases is used.

6. Method according to any of the preceding claims, **characterized in that** at least one of the layers is deposited as a gradient layer.

7. Method according to any of the preceding claims, **characterized in that** at least one of the layers is deposited as a silicon oxide and/or titanium oxide and/or aluminium oxide layer.

8. Method according to any of the preceding claims, **characterized in that** at least one of the deposited layers is used to modify at least one of the following properties of the substrate (1): scratch resistance, barrier behaviour, transmission behaviour, refractive index, light scattering, electrical conductivity, antibacterial behaviour, friction, adhesion, hydrophilicity, hydrophobicity, oleophobicity, oleophilicity, surface tension, surface energy, anti-corrosive effect, self-cleanability, photocatalytic behaviour, anti-stress behaviour, wear behaviour, chemical resistance, biocidal behaviour, biocompatible behaviour, electrostatic behaviour, electrochromic activity.

9. Method according to any of the preceding claims, **characterized in that** prior to the deposition an activating operation is carried out wherein the substrate (1) is treated with the plasma jet or the flame without supply of precursor material.

10. Method according to any of the preceding claims, **characterized in that** the deposition takes place directly after an operation of producing the substrate (1), wherein the substrate (1) has been formed with supply of heat.

11. Method according to any of the preceding claims, **characterized in that** a temperature of the substrate (1) is in a range from 20°C to 200°C.

12. Method according to any of the preceding claims, **characterized by** the coating of a substrate (1) composed of one of the substances glass, plastic, metal and ceramic.

13. Method according to any of the preceding claims, **characterized in that** in the layer at least one oxide and/or nitride and/or oxynitride of at least one of the elements silicon, titanium, aluminium, molybdenum, tungsten, vanadium, zirconium or boron is deposited.

14. Method according to any of the preceding claims, **characterized in that** at least one of the deposited layers is implemented as a diffusion barrier relative to at least one alkali metal element and/or of at least one alkaline earth metal element and/or boron and/or tungsten.

15. Method according to any of the preceding claims, **characterized in that** at least one of the deposited layers is implemented as a diffusion barrier relative to at least one of the substances oxygen, water, water vapour, carbon dioxide and/or organic solvents, more particularly from plastics.

## Revendications

1. Procédé pour le dépôt d'une couche sur un substrat (1), dans lequel on génère, à partir d'un gaz de travail, un jet de plasma ou une flamme, au moins un matériau précurseur étant alimenté dans le gaz de travail et/ou dans le jet de plasma et/ou dans la flamme et amené à réagir dans le jet de plasma ou dans la flamme et au moins un produit de réaction d'au moins un des précurseurs étant déposé sur une surface du substrat (1) et/ou sur au moins une couche disposée sur la surface, au moins un des précurseurs étant additionné de nanoparticules ou le gaz de travail et/ou le jet de plasma et/ou la flamme étant alimenté(e) en une dispersion additionnée de nanoparticules, les nanoparticules étant enrobées dans au moins une des couches déposées, **caractérisé en ce qu'**on utilise comme nanoparticules des nanotubes en carbone et/ou les plaquettes en carbone et/ou des particules d'argent et/ou des nanotubes en carbone contenant de l'argent et/ou des plaquettes en carbone auxquelles adhère de l'argent.

2. Procédé selon la revendication 1, **caractérisé en ce que** le procédé est réalisé à pression atmosphérique.

3. Procédé selon l'une quelconque des revendications précédentes, **caractérisé en ce qu'**on utilise comme précurseur un composé organique du silicium et/ou du titane et/ou de l'aluminium.

4. Procédé selon l'une quelconque des revendications précédentes, **caractérisé en ce que** les nanoparticules sont dispersées dans un milieu de dispersion et/ou dans un des précurseurs servant de dispersant.

5. Procédé selon l'une quelconque des revendications précédentes, **caractérisé en ce qu'**on utilise un des gaz de travail que sont l'air, l'oxygène, l'azote, les gaz nobles, l'hydrogène, le dioxyde de carbone, l'ammoniac, les hydrocarbures gazeux ou un mélange d'au moins deux des gaz susmentionnés.

6. Procédé selon l'une quelconque des revendications précédentes, **caractérisé en ce qu'**au moins une des couches est déposée sous forme de couche à gradient.

7. Procédé selon l'une quelconque des revendications précédentes, **caractérisé en ce qu'**au moins une des couches est déposée sous forme de couche d'oxyde de silicium et/ou d'oxyde de titane et/ou d'oxyde d'aluminium.

8. Procédé selon l'une quelconque des revendications précédentes, **caractérisé en ce qu'**au moyen d'au moins une des couches déposées, au moins une des propriétés du substrat (1), la résistance aux rayures, le comportement de barrière, le comportement de transmission, l'indice de réfraction, la dispersion de la lumière, la conductibilité électrique, le comportement antibactérien, le frottement, l'adhérence, l'hydrophilie, l'hydrophobie, l'oléophobie, l'oléophilie, la tension superficielle, l'énergie superficielle, l'effet anticorrosif, l'aptitude à l'autonettoyage, le comportement photocatalytique, le comportement anticontrainte, le comportement d'usure, la résistance aux substances chimiques, le comportement biocide, le comportement biocompatible, le comportement électrostatique, l'activité électrochome, est modifiée.

9. Procédé selon l'une quelconque des revendications précédentes, **caractérisé en ce qu'**un procédé d'activation est réalisé avant le dépôt, dans lequel le substrat (1) est traité par le jet de plasma ou la flamme sans alimentation d'un matériau précurseur.

10. Procédé selon l'une quelconque des revendications précédentes, **caractérisé en ce que** le dépôt a lieu directement après un procédé de production du substrat (1) dans lequel le substrat (1) a été formé sous alimentation de chaleur.

11. Procédé selon l'une quelconque des revendications précédentes, **caractérisé en ce que** la température du substrat (1) se situe dans une plage de 20°C à 200°C.

12. Procédé selon l'une quelconque des revendications précédentes, **caractérisé par** le revêtement d'un substrat (1) constitué par une des matières que sont le verre, le matériau synthétique, le métal et la céramique.

13. Procédé selon l'une quelconque des revendications précédentes, **caractérisé en ce qu'**on dépose dans la couche au moins un oxyde et/ou un nitrure et/ou un oxynitrure d'au moins un des éléments silicium, titane, aluminium, molybdène, tungstène, vanadium, zirconium ou bore.

14. Procédé selon l'une quelconque des revendications précédentes, **caractérisé en ce qu'**au moins une des couches déposées est réalisée sous forme de barrière de diffusion par rapport à au moins un élément de métal alcalin et/ou un élément de métal alcalino-terreux et/ou au bore et/ou au tungstène.

15. Procédé selon l'une quelconque des revendications précédentes, **caractérisé en ce qu'**au moins une des couches déposées est réalisée sous forme de barrière de diffusion par rapport à au moins une des substances que sont l'oxygène, l'eau, la vapeur d'eau, le dioxyde de carbone et/ou les solvants organiques, en particulier de matériaux synthétiques.
